# EUROPEAN PATENT APPLICATION

(11) **EP 2 487 496 A1**
(43) Date of publication of application: **15.08.2012**
(21) Application number: 11154141.3
(22) Date of filing: 11.02.2011
(51) Int. Cl.: G01R 31/00, G01R 31/02

(54) **Method for isolation measurements using pre-charge and discharge circuitry**

(71) Applicant: SAAB AUTOMOBILE AB, 461 80 Trollhättan (SE)
(72) Inventor: Martander, Olof, 461 58 Trollhättan (SE); Hermansson, Leif, 467 94 Grästorp (SE); Ehner, Marcus, 461 58 Trollhättan (SE)
(74) Representative: Edlund, Fabian

(57) **Abstract**

A method for measuring isolation of an electrical system in a vehicle, the system comprising an AC/DC inverter (2), an AC motor (3), and an energy storage system (1), the ESS having a positive bus (16) and a negative bus (17) connectable to a first and second terminal (4, 5) of the DC-side of the inverter, respectively, a charging resistor (25), connectable in series with the ESS during charging of a capacitance (30) of the inverter, and a discharge resistor (26) connectable between said first and second terminals for discharge of said capacitance (30). The method comprises connecting said discharge resistor (26) between said first and second terminals (4, 5), connecting one bus (16 or 17) of said ESS to one of said first and second terminals (4, 5), and conducting an isolation measurement of said ESS.

According to this method, an isolation measurement can be performed for the entire electrical system, i.e. the energy storage system, the motor, and the inverter, also before system start-up and post drive, i.e. when the inverter is deactivated and not in high voltage mode.

## Description

### Background

The electrical system of a vehicle typically comprises an energy storage system (ESS), such as a battery, an inverter for converting DC voltage from the ESS to AC voltage, and an electrical AC motor adapted to operate as a motor or generator. This electrical system is held isolated from ground to prevent any danger of short circuits and electrical hazard.

Measurements of the isolation of the ESS are typically performed continuously during driving, but also before start-up of the system. A conventional procedure for such general isolation measurements is disclosed in the standard SAE J1766 APR2005,.

Any electrical faults associated with the inverter or electrical motor or cables associated herewith are only measured during operation, when the motor is connected to the energy storage system. Examples of methods for such measurements are disclosed in US 6,381,110 and US 2010/0244760.

In order to further improve the isolation measurement, it is desirable to measure the entire system also before start-up or post drive (after deactivation of the high voltage).

### Summary of the invention

This and other objects are achieved by a method for measuring isolation of an electrical system in a vehicle, the system comprising an AC/DC inverter having an AC-side and a DC-side, an AC motor connected to the AC-side of the inverter, an energy storage system having a positive bus and a negative bus connectable to a first and second terminal of the DC-side of the inverter, respectively, a charging resistor, connectable in series with the ESS during charging of a capacitance of the inverter, and a discharge resistor connectable between the first and second terminals for discharge of the capacitance. The method comprises connecting the discharge resistor between the first and second terminals, connecting one bus of the ESS to one of the first and second terminals, and conducting an isolation measurement of the ESS.

According to this method, an isolation measurement can be performed for the entire electrical system, i.e. the energy storage system, the motor, and the inverter, also before system start-up and post drive, i.e. when the inverter is deactivated and not in high voltage mode.

The present invention is based on the insight that the inverter of the electrical system can be connected to the energy storage system in such a way that both terminals of the inverter are held at a controlled positive potential. Such a connection may typically be accomplished using existing wiring and breakers of the electrical system. In many systems, however, the wiring and breakers required to realize the invention are divided between the inverter and the energy storage system. Therefore, a connection according to the invention has not been previously contemplated.

According to one embodiment, isolation measurement according to the present invention can also be performed with the inverter in high voltage state, but when the engine is inactive. Such a measurement requires that the discharge resistance comprises two separate resistances, with one breaker for each resistor, and a point between the two breakers is connected to one of the engine windings.

It is noted that this aspect of the invention may also be advantageous without limitation to the features included in the claim 1 as filed, and thus may form a separate inventive concept.

### Brief description of the drawings

Figure 1 shows a schematic block diagram of an electrical system of a vehicle implementing a first embodiment of the present invention.
Figure 2 shows a schematic block diagram of an electrical system of a vehicle implementing a second embodiment of the present invention.
Figure 3 shows a schematic block diagram of an electrical system of a vehicle implementing a third embodiment of the present invention.

### Detailed description of preferred embodiments

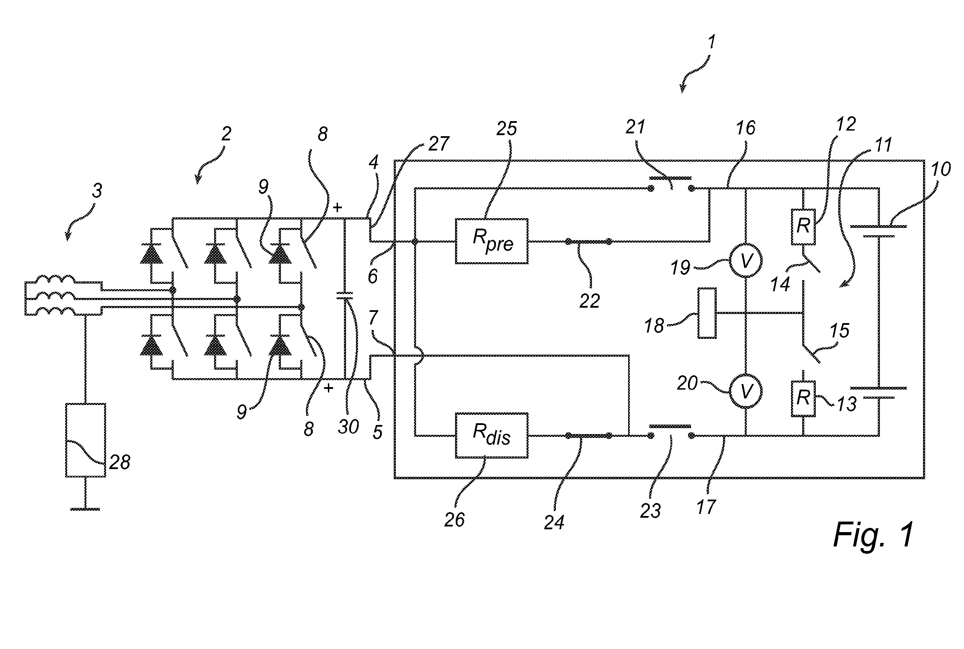

The electrical system in figure 1 comprises an energy storage system (ESS) 1, a DC/AC inverter 2, and an electrical AC motor 3. The ESS 1, comprising a positive bus 16 and a negative bus 17, is adapted to power the motor 3 via the inverter 2, and the AC motor 3 is connected to the engine of the vehicle (not shown), in order to operate as a generator to charge the ESS 1.

The inverter has two terminals 4 and 5 for receiving DC voltage from a positive pole 6 and a negative pole 7 of the ESS 1, and includes a capacitor 30 for providing high voltage, and a plurality (here six) switches 8, each connected in series with a diode 9, for providing a three phase AC voltage to the motor 3.The ESS 1 comprises an energy storage 10 (e.g. a battery) and an isolation measurement arrangement 11 connected in parallel with the battery 11. The measurement arrangement 11 here includes a first resistor 12 with resistance R₀ connected in series with a switch 14 between the positive bus 16 and ground 18, and a second resistor 13 with resistance R₀ connected in series with a switch 15 between the negative bus 17 and ground 18. Further, a first voltmeter 19 is connected between the positive bus 16 and ground 18, in parallel with the resistor 12 and switch 14, and a second voltmeter 20 is connected between the negative bus 17 and ground 18, in parallel with the resistor 13 and switch 15.

The positive bus 16 is connectable directly to the positive pole 6 of the ESS 1 via a first switch 21, and to the same pole 6 in series with a charging resistor 25 via a second switch 22. The negative bus 17 is connectable directly to the negative pole 7 of the ESS 1 via a third switch 23. Finally, a discharge resistor 26 is connectable between the two poles 6, 7 via a fourth switch 24.

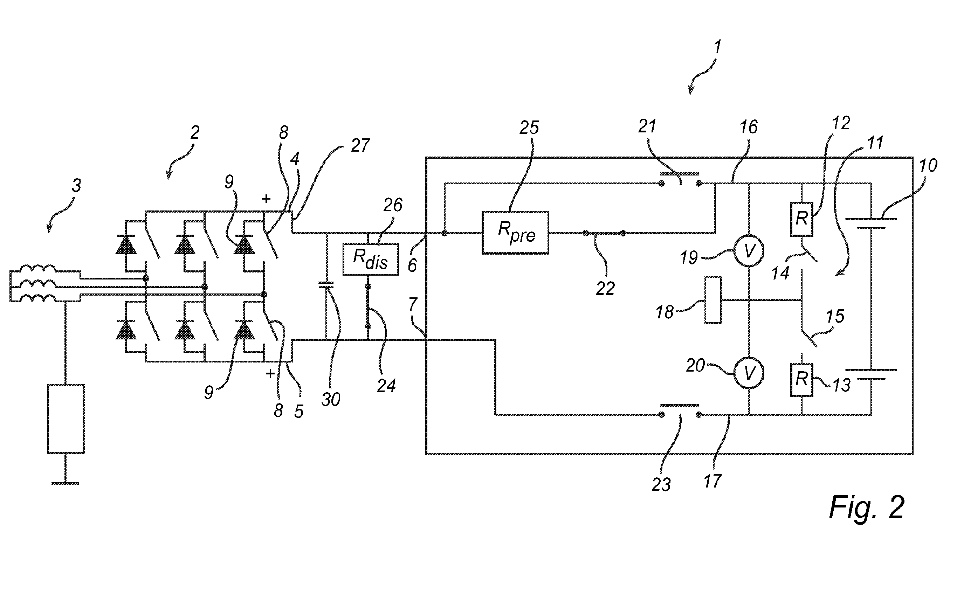

According to a second embodiment, illustrated in figure 2, the discharge resistor 26 and fourth switch 24 are instead provided in the inverter 2. The placement of the discharge resistor 26 and switch 24 is a question of design, and does not affect the principles of the present invention.

The charging resistor 25, the discharge resistor 26, and the four switches 21, 22, 23, 24 are here illustrated as forming part of the ESS 1. One or several of these elements may equally well form part of the inverter 2, or be separately arranged between the ESS 1 and the inverter 2.

When the system is inactive, all switches 21-24 are open, and the ESS 1 is effectively disconnected from the inverter 2. The inverter is thus deactivated, and is not in a high voltage state. During start-up, switches 22 and 23 are closed, and the capacitance 30 of the inverter is charged through the charge resistor, to thereby put the inverter in a high-voltage state. During normal operation, switches 21 and 23 are closed, and the inverter stays in high-voltage state (capacitor 30 charged). In this mode, the inverter will be active (switching) when the motor is running, and inactive (no switching) when the motor is not running. Finally, during discharge, switch 24 is closed, thereby connecting the discharge resistor 26 between the terminals 4, 5 of the inverter 2 in order to discharge the capacitance 30.

Conventionally, an isolation measurement before start-up of the system is performed with all switches 21-24 open. In this state, the ESS 1 is completely disconnected from the inverter 2, and the isolation measurement will only detect any isolation fault internally within the ESS 1. The isolation measurement can be performed as described in SAE J1766 APR2005, and will only be briefly described here.

First, the voltage V_{bus} between the positive and negative buses 16, 17 is measured. Then, both resistors 12, 13 are disconnected, and the voltages V1 and V2 between each bus 16, 17 and ground 18 are measured (with the voltmeters 19, 20).

Then, for the greater of V1 and V2, a second measurement is performed, this time with the corresponding resistor 12, 13 connected. In other words, if V1 is greater than (or equal to) V2, then resistor 12 is connected and a voltage V1' is measured (with voltmeter 19). If V2 is greater than V1, then resistor 13 is connected and a voltage V2' is measured (with voltmeter 20).

The electrical isolation Rᵢ is then calculated according to Ri=R₀xV_{bus}(1/Vx-1/Vx'), where x is 1 or 2 depending on the relative magnitude of V1 and V2. An isolation fault will cause a decreased electric isolation, Ri.

According to the present invention, a second, more complete, measurement can be performed before start-up by closing switches 22 and 24. This measurement will detect any isolation fault in the motor 3 and inverter 2.

By closing switch 24, the terminals 4, 5 of the inverter 2 are connected to each other via the discharge resistor 26. By closing switch 22, both terminals are then connected to the positive bus 6. The diodes 9 in the lower part of figure 1 will ensure that the motor 3 is held at a positive potential, making it possible to detect isolation faults in the inverter 2 as well as the motor 3.

The isolation measurement is then performed as outlined above, and will include the inverter 2 and motor 3 as belonging to the positive side of the ESS 1.

Again, an isolation fault, e.g. in the form of a leak resistance 28, will result in a decreased total isolation Ri. The leak resistance 28 may be located anywhere in the system, and is illustrated in figure 1 in connection to the engine.

It should be noted that a variety of other measurement procedures may be possible in order to detect an isolation fault when the breakers 22 and 24 closed. In particular, it may be possible to detect an isolation fault based only on V1 and V2 (i.e. without performing the second voltage measurement).

In principle, a third, intermediate, measurement is also possible by closing only switch 22 (not switch 24). This measurement will detect any isolation fault in the connection line 27, connecting the first terminal 4 of the inverter with the positive pole 6 of the ESS 1. Such an intermediate measurement can be used e.g. to locate a fault which has been detected in a complete measurement with switches 22 and 24 closed.

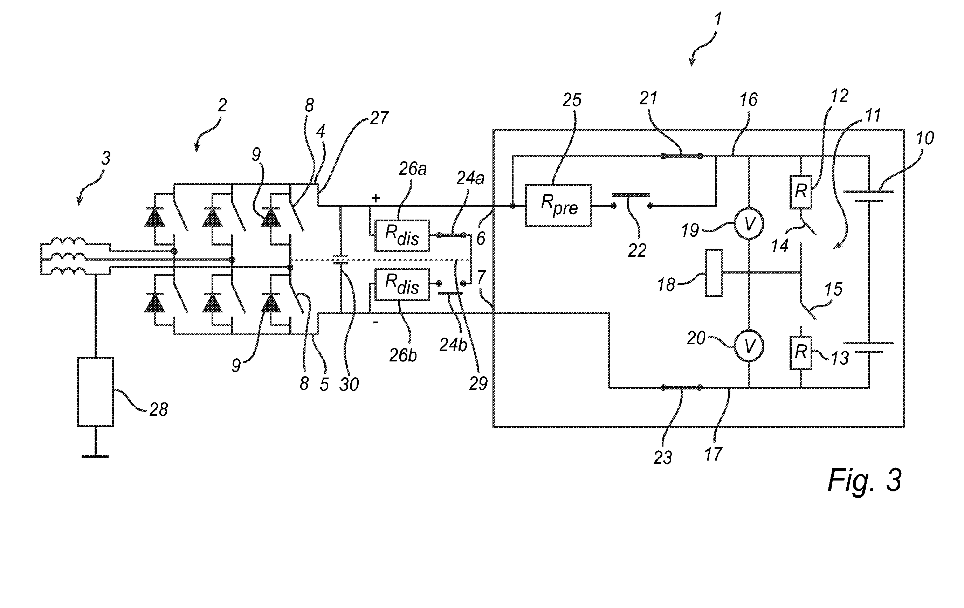

Figure 3 shows a further embodiment of the present invention. According to this embodiment, the discharge resistor includes two resistors 26a, 26b, and the switch 24 includes two separate switches 24a, 24b connected in series between the resistors 26a, 26b. The connection point between the resistors is connected to one of the windings of the AC motor via a line 29.

According to this embodiment, a further measurement mode is available when the inverter is in high voltage state but deactivated, i.e. the inverter capacitance 30 is charged, but the switching is inactivated and the motor is not running. Under these conditions, an isolation measurement of the entire system may be performed by closing either switch 24a or switch 24b while keeping the other switch open.

It is noted that the measurement method described with reference to figure 3 may be used without limitation to the other measurement methods described herein. In particular, this method may be used without implementing the intermediate measuring mode described with reference to figures 1 and 2, where switches 22 and 24 are closed.

The skilled person realizes that the present invention by no means is limited to the preferred embodiments described above. On the contrary, many modifications and variations are possible and within the scope of the appended claims. For example, the number of switches and their location may be different. Further, other types of measurement principles may be employed in the various modes.

Especially, it shall be recognized that the described isolation measurement, disclosed in the standard SAE J1766 APR2005, can be used also in normal operation, i.e. with the switches 21 and 23 closed.

## Claims

1. A method for measuring isolation of an electrical system in a vehicle, said system comprising
an AC/DC inverter (2) having an AC-side and a DC-side,
an AC motor (3) connected to the AC-side of the inverter,
an energy storage system (1) having a positive bus (16) and a negative bus (17) connectable to a first and second terminal (4, 5) of the DC-side of the inverter, respectively,
a charging resistor (25), connectable in series with the ESS during charging of a capacitance (30) of the inverter, and
a discharge resistor (26) connectable between said first and second terminals for discharge of said capacitance (30),
said method comprising:
connecting said discharge resistor (26) between said first and second terminals (4,5),
connecting one bus (16 or 17) of said ESS to one of said first and second terminals (4, 5), and
conducting an isolation measurement of said ESS.

2. The method according to claim 1, wherein the discharge resistor (26) and a switch (24) for connecting said discharge resistor are provided in the inverter (2).

3. The method according to claim 1 or 2, said method being performed when said inverter (2) is deactivated.

4. The method according to claim 3, wherein said discharge resistor (26) is divided into two resistor elements (26a, 26b), the method being performed when the inverter is in a high voltage state but with no switching performed, the step of connecting the discharge resistor including:
connecting one of said resistor element between one of the inverter terminals (4, 5) and the motor (3).

5. The method according to claim 1, wherein said isolation measurement includes the steps:
a) measuring a voltage V_{bus} between the positive and negative buses
b) measuring voltages V1 and V2 between each bus 16, 17 and ground 18, respectively,
c) if V1 is greater than or equal to V2, measuring a voltage V1' over a known resistance between the positive bus and ground, and if V2 is greater than V 1 measuring a voltage V2' over a known resistance between the positive bus and ground,
d) calculating an electrical isolation Rᵢ according to Rᵢ=R₀xVb(1/Vx-1/Vx'), where R₀ is the known resistance, and x is 1 if V1>=V2 and x is 2 otherwise.
